# EUROPÄISCHE PATENTSCHRIFT

(11) **EP 2 954 264 B1**
(45) Veröffentlichungstag und Bekanntmachung des Hinweises auf die Patenterteilung: **25.11.2020**
(21) Anmeldenummer: 14703075.3
(22) Anmeldetag: 06.02.2014
(51) Int. Cl.: F24S 10/20, H02S 40/44, H01L 31/0525, H01L 31/054, F24S 20/20, F24S 10/40

(54) **RECEIVER FÜR SOLARANLAGEN UND SOLARANLAGE**
RECEIVER FOR SOLAR PLANTS AND SOLAR PLANT
RÉCEPTEUR POUR INSTALLATIONS SOLAIRES ET INSTALLATION SOLAIRE

(30) Priorität: 06.02.2013 DE 102013201938
(43) Veröffentlichungstag der Anmeldung: 16.12.2015
(73) Patentinhaber: Sunoyster Systems GmbH, 25469 Halstenbek (DE)
(72) Erfinder: CORINO, Carsten, 25469 Halstenbek (DE); WERNICKE, Thies, 12309 Berlin (DE)
(74) Vertreter: Weidner Stern Jeschke
(86) Internationale Anmeldenummer: PCT/EP2014/052359
(87) Internationale Veröffentlichungsnummer: WO 2014/122224

(56) Entgegenhaltungen:
- EP-A1- 0 785 400
- CN-U- 202 135 083
- DE-A1-102008 021 730
- DE-U1- 29 601 105
- US-A- 4 249 516
- US-A1- 2009 056 699
- US-A1- 2010 229 852
- US-A1- 2011 226 308

## Beschreibung

Die Erfindung betrifft Receiver für die Anordnung in der Fokuslinie eines Solarkollektors mit einem linienförmig fokussierenden Spiegelelement sowie eine Solaranlage mit einem entsprechenden Receiver.

Es sind Solarkollektoren bekannt, bei denen die einfallende Sonnenstrahlung durch optische Elemente auf eine Linie fokussiert wird. Typische Beispiele für entsprechende optische Elemente sind Parabolrinnen. Entlang der Fokuslinie eines entsprechenden Solarkollektors ist ein Receiver angeordnet, der die durch das optische Element gebündelte Sonnenstrahlung in Nutzenergie umwandelt.

Als Receiver sind zum einen thermische Receiver bekannt, bei denen die linienförmig gebündelte Sonnenstrahlung auf ein Absorberrohr auftrifft, welches von einem Wärmeträgerfluid durchströmt wird. Das Wärmeträgerfluid wird dabei erwärmt und die so gewonnene Wärmeenergie kann anschließend genutzt werden. Um den Wirkungsgrad eines entsprechenden Receivers zu erhöhen, ist es bekannt, das Absorberrohr doppelwandig auszugestalten. Dabei ist die innere Rohrwand derart gestaltet, dass sie einen hohen Absorptionsgrad für Sonnenstrahlung aufweist, während die äußere Rohrwand einen hohen Transmissionsgrad für Sonnenstrahlung aufweist. Der Zwischenraum zwischen den beiden Rohrwänden ist vakuumiert. Die innere Rohrwand, durch die das Wärmeträgerfluid strömt, ist dadurch thermisch von der Umgebung isoliert.

Weiterhin sind duale Receiver bekannt, bei denen die linienförmig gebündelte Sonnenstrahlung auf Photovoltaikzellen auftrifft, mit denen die Sonnenstrahlung wenigstens teilweise in elektrische Energie umgewandelt wird. Auf der Rückseite der Photovoltaikzellen ist ein mit Wärmeträgerfluid durchströmtes Kühlrohr angeordnet, um die Temperatur der Photovoltaikzellen in einem zulässigen Bereich zu halten. Die dabei auftretende Erwärmung des Wärmeträgerfluids kann als Wärmeenergie genutzt werden.

Die CN 202 135 083 U offenbart bereits einen Receiver für die Anordnung in der Fokuslinie eines Solarkollektors mit einem linienförmig fokussierenden Spiegelelement gemäß dem Oberbegriff des Anspruchs 1. Zur Optimierung des elektrischen Wirkungsgrades ist der Receiver direkt über dem linienförmig fokussierenden Spiegelelement angeordnet, so dass die Sonnenstrahlung ohne Abschwächung auf die Konzentratorelemente des strahlmanipulierenden Elements auftrifft. Jedoch wird durch Wärmeabstrahlung an die Umgebung der thermische Wirkungsgrad des Solarkollektors verringert.

Aus der US 2011/226308 A1 ist es bereits bekannt, ein von einem Wärmeübertragerfluid durchströmtes Hohlprofil mit daran angebrachten Solarzellen in einem vorzugsweise vakuumierten transparenten Hüllrohr anzuordnen, um die Wärmeverluste durch Konvektion vom Hohlprofil zur Wand des Hüllrohrs zu minimieren.

Weitere ähnliche Receiver sind aus der DE 10 2008 021 730 A1, der DE 296 01 105 U1, der EP 0 785 400 A1, der US 4 249 516 A, der US 2012/229852 A1 und der US 2009/056699 A1 bekannt.

Der Erfindung liegt die Aufgabe zugrunde, einen verbesserten Receiver für die Anordnung in der Fokuslinie eines Solarkollektors mit einem linienförmig fokussierenden Spiegelelement sowie eine verbesserte Solaranlage zu schaffen.

Diese Aufgabe wird gelöst durch einen Receiver gemäß dem Hauptanspruch und eine Solaranlage gemäß dem nebengeordneten Anspruch. Vorteilhafte Weiterbildungen sind Gegenstand der abhängigen Ansprüche.

Demnach betrifft die Erfindung einen Receiver für die Anordnung in der Fokuslinie eines Solarkollektors mit einem linienförmig fokussierenden Spiegelelement, der ein langgestrecktes Hohlprofil zur Durchleitung von Wärmeträgerfluid und auf einer Seite des Hohlprofils angeordnete Solarzellen zur Umwandlung von Sonnenstrahlung in elektrische Energie umfasst, wobei die Solarzellen und das Hohlprofil wärmeleitend verbunden sind und das Hohlprofil mit den darauf angeordneten Solarzellen in einem transparenten Hüllrohr in der Weise angeordnet ist, dass zwischen Hüllrohr und den Solarzellen mindestens ein strahlmanipulierendes Element angeordnet ist, wobei die Lage von Hohlprofil, Solarzellen, Hüllrohr und dem strahlmanipulierenden Element des Receivers zueinander fest ist.

Die Erfindung betrifft weiterhin eine Solaranlage mit einem linienförmig fokussierenden Spiegelelement, in dessen Fokuslinie ein Receiver angeordnet ist, wobei der Receiver erfindungsgemäß ausgebildet und derart angeordnet ist, dass die Solarzellen dem linienförmig fokussierenden optischen Spiegelelement zugewandt sind.

Unter einem "strahlmanipulierenden Element" wird ein optisches Element verstanden, welches einen Lichtstrahl bricht, reflektiert oder beugt.

Bei dem erfindungsgemäßen Receiver wird die Sonnenstrahlung sowohl in elektrische Energie als auch in Wärmeenergie umgewandelt. Die Erfindung hat erkannt, dass auch bei entsprechend kombinierten Receivern mit von Wärmeträgerfluid durchströmten Hohlprofilen und darauf angeordneten Solarzellen die Anordnung in einem transparenten Hüllrohr besonders vorteilhaft dann wirkt, wenn das strahlmanipulierende Element, das Hüllrohr und Hohlprofil sowie die Solarzelle fest zueinander positioniert sind. Dabei wird entgegen dem Vorurteil der Fachwelt, wonach Sonnenstrahlung mit möglichst wenig Störungen auf Solarzellen auftreffen soll um einen möglichst hohen Wirkungsgrad zu erreichen, ein für die Bündelung der Sonnenstrahlung auf die Solarzellen nicht benötigtes Element - nämlich die Wand des Hüllrohrs - in den Strahlengang zwischen Sonne und Solarzellen eingebracht. Die damit einhergehende Verringerung des Wirkungsgrads bei der Erzeugung elektrischer Energie durch die Solarzellen wird durch die Verringerung der Wärmeverluste und damit der Erhöhung des Wirkungsgrades bei der Wärmeenergiegewinnung sowie durch die Wirkung des dort angeordneten strahlmanipulierenden Elements mehr als ausgeglichen. Darüber hinaus bietet das Hüllrohr den Vorteil, dass die innen liegenden Solarzellen und das strahlmanipulierende Element vor schädlichen Umwelteinwirkungen bspw. durch Wasser geschützt sind und die Reinigung des Receivers bei Verschmutzung vereinfacht ist.

Diese Vorteile verknüpft die Verbindung mit einem einfachen Aufbau des Receivers, bei dem vollständig auf bewegliche Elemente verzichtet werden kann. Eine Wartung des Receivers, der bspw. eine vollständige oder teilweise Demontage, eine Öffnung des Hüllrohres oder das Vorsehen von Wartungsklappen o. ä. erfordern würde, kann so vermieden werden. Ein entsprechender Receiver mit strahlmanipulierenden Elementen ist dann besonders für Solaranlagen mit zweiachsiger Nachführung, also hinsichtlich der Elevation und des Azimut, geeignet.

Erfindungsgemäß sind die strahlmanipulierenden Elemente zwischen Hüllrohr und Hohlprofil als optische Konzentratorelemente ausgeführt, mit denen linienförmig fokussiert auf den Receiver auftreffende Sonnenstrahlen in einzelne Fokuspunkte entlang der Fokuslinie gebündelt werden. In den Fokuspunkten sind dann die Solarzellen angeordnet. Durch eine entsprechende zweite Fokussierung der Sonnenstrahlung von einer Fokuslinie zu einzelnen Fokuspunkten wird die Strahlungsintensität an diesen Punkten derart erhöht, dass Konzentrator-Photovoltaikzellen als Solarzellen eingesetzt werden können, um die Sonnenstrahlung in elektrische Energie umzuwandeln. Als optische Konzentratorelemente können lineare Fresnellinsen vorgesehen sein, die senkrecht zur Ausdehnung des Hohlprofils ausgerichtet sind. Die einzelnen Solarzellen sind vorzugsweise jeweils einzeln mit einer Bypass-Diode geschützt.

Es kann vorgesehen sein, dass das strahlmanipulierende Element als Strahlteiler ausgeführt ist, der einfallende Solarstrahlung abhängig von der Wellenlänge aufspaltet und auf die für die jeweilige Wellenlänge optimierte Solarzelle umlenkt. Es sind dann also verschiedene Arten von Solarzellen vorgesehen. Der Strahlteiler kann insbesondere als Strahlteilerwürfel, als Stahlteilerplatte oder als (Transmissions-)Gitter ausgestaltet sein. Eine entsprechende Aufspaltung der einfallenden Solarstrahlung ermöglicht den Einsatz von kostengünstigeren Solarzellen.

Es sei angemerkt, dass die vorgenannte Strahlkonzentration einerseits und die Strahlteilung andererseits erfindungsgemäß kombiniert vorgesehen sind. Der Bereich zwischen Hohlprofil und Hüllrohr kann vakuumiert sein. Dadurch wird eine gute Wärmeisolierung des Hohlprofils erreicht. Insbesondere im Zusammenhang mit einem Vakuum im Bereich zwischen Hohlprofil und Hüllrohr aber auch bei anderen Ausführungsformen ist es bevorzugt, wenn das Hohlprofil und/oder das Hüllrohr aus Glas gefertigt sind. Ein Vakuum im Bereich zwischen Hohlprofil und Hüllrohr kann so dauerhaft erhalten bleiben. Außerdem ist Glas gegenüber vielen Stoffen und insbesondere vielen Wärmeträgerfluiden korrosionsfest. Die im Bereich zwischen Hohlprofil und Hüllrohr angeordneten Elemente, wie bspw. die Solarzellen, sind bevorzugt ausgasungsfest ausgestaltet. Es kann auch vorgesehen sein, dass der Bereich zwischen Hohlprofil und Hüllrohr mit Edelgas gefüllt ist.

Um das Hüllrohr hermetisch gegenüber Kontaminationen abzudichten kann vorgesehen sein, an beiden Enden des Hüllrohrs Gasanschlüsse vorzusehen. Damit kann der Bereich zwischen Hohlprofil und Hüllrohr auf einfache und effektive Weise gespült werden, insbesondere mit Edelgas.

Auf der von den Solarzellen abgewandten Seite des Hohlprofils kann zwischen Hohlprofil und Hüllrohr wenigstens ein Reflektor vorgesehen sein. Er ist dazu ausgebildet, die von dem Hohlprofil stammende Wärmestrahlung auf dieses zurück zu werfen, womit der Wärmeverlust weiter reduziert werden kann. Er ist ferner dazu ausgebildet, vom strahlmanipulierenden Element stammende Lichtstrahlung, welche das Hohlprofil - insbesondere wegen Fehlfokussierung - verfehlt hat, auf das Hohlprofil zurückzuwerfen. Dieser wenigstens eine Reflektor kann direkt auf das Hüllrohr aufgebracht (z. B. aufgedampft) sein oder aus einer Metallfolie (bspw. Aluminiumfolie) sein, die vorzugsweise mehrlagig ausgestaltet ist und wärmebeständige Trennschichten zwischen den einzelnen Folien aufweist.

Das strahlmanipulierende Element kann einstückig mit dem Hüllrohr ausgebildet sein. Beispielsweise können die strahlmanipulierenden Elemente in das Hüllrohr gefräst sein. Auch können sie in das Hüllrohr gepresst sein. Die Anzahl der einzelnen Bauteile für den erfindungsgemäßen Receiver kann so reduziert werden. Es kann auch vorgesehen sein, die strahlmanipulierenden Elemente dauerhaft mit dem Hüllrohr zu verbinden, beispielsweise indem sie direkt auf das Hüllrohr aufgeklebt oder mit Silikon auf dieses aufmodelliert werden. Mit einer solchen Kombination ist die Montage im Feld erleichtert und es wird ferner auf einfache Weise eine präzise Positionierung zwischen strahlmanipulierendem Element und Hüllrohr erreicht.

Das Hohlprofil ist vorzugsweise halbzylindrisch oder hufeisenförmig ausgeführt. Unter hufeisenförmig wird eine Form verstanden, die ähnlich wie ein Halbzylinder ausgestaltet ist, wobei jedoch die Sekante nicht wie beim Halbzylinder durch den Mittelpunkt läuft, sondern höher oder tiefer. Dies bietet mit der Sekante eine ebene Vorderseite zur Aufnahme der Solarzellen, während die etwa halbrund gestaltete Rückseite kongruent zur Innenwandung des Hüllrohrs geformt ist und so dort für eine sichere und stabile Lagerung sorgt. Man erreicht damit einen optimal großen Querschnitt für das im Hohlprofil strömende Wärmeträgerfluid. Besonders zweckmäßig ist hierbei, wenn die ebene Vorderseite geglättet ist, beispielsweise durch Planfräsung. Damit ergibt sich eine großflächige Anlage der Solarzellen an dem Hohlprofil, was die Wärmeübertragung und damit die Effizienz verbessert.

Mit Vorteil können an der Vorderseite des Hohlprofils beispielsweise gefräste Ausnehmungen oder leistenartige Hervorstehungen vorgesehen werden, um so großflächige Aufnahmetaschen für die Solarzellen, insbesondere aus mehreren Solarzellen bestehende Paneele, zu bilden.

Das Hohlprofil ist zweckmäßigerweise mit mindestens einer (bei mehreren voneinander beabstandeten) Haltescheiben in dem Hüllrohr fixiert. Die Haltescheiben sind mit ihrer Außenkontur auf die Innenwandung des Hüllrohrs abgestimmt und sorgen so für eine sichere spielfreie Positionierung des Hohlprofils in dem Hüllrohr. Mit Vorteil sind die Haltescheiben zweiteilig ausgeführt, so dass sie zur leichteren Montage einfach auf das Hohlprofil aufgesteckt und dann miteinander verbunden werden können. Es hat sich bewährt, die Haltescheiben in ihrem oberen, dem Spiegelelement zugewandten Bereich mit einem Ausschnitt zu versehen, der bis zur Solarzelle reicht. Dann ist ein verschattungsfreier Strahlengang zur Solarzelle auch dann gewährleistet, wenn die Azimutausrichtung des Spiegels bzw. Receivers nicht optimal ist und das Licht somit seitlich schräg einfällt.

Um das Verhalten bei Erwärmung zu verbessern, ist vorzugsweise das Hohlprofil bezüglich seiner thermischen Längenausdehnung so eingestellt, dass sie betragsmäßig etwa gleich ist zu derjenigen des Hüllrohrs. Das kann insbesondere durch die Wahl des Materials geschehen, aus dem das Hohlprofil hergestellt wird. Es wird eine solche Legierung verwendet, die bei den zu erwartenden Betriebstemperaturen das Hohlprofil durch thermische Längenänderung genauso weit sich dehnt wie das Hüllrohr. Verspannungen sind dadurch auf ein Minimum reduziert, was ein erheblicher Vorteil für die Dichtigkeit ist und insbesondere bei vakuumierten Hüllrohren zu einer beträchtlichen Erhöhung der Betriebssicherheit sorgt. Mit Vorteil besteht das Hohlprofil zumindest teilweise aus Graphit.

Um einen effektiven Wärmeübergang zwischen Solarzellen und Hohlprofil zu gewährleisten ist erfindungsgemäß wenigstens ein Spannelement vorzusehen, welches das Hohlprofil und wenigstens eine Solarzelle derart umgreift, dass die wenigstens eine Solarzelle an das Hohlprofil angepresst wird. Besonders zweckmäßig ist es, das Spannelement als ein Klemmelement auszuführen. Das Klemmelement kann bspw. aus Federstahl sein. Vorzugsweise weist das Spannelement mehrere Finger auf, und zwar in seinem auf die Solarzelle wirkenden Bereich. Damit ist eine sichere und wärmeleitungstechnische günstige Ankopplung der Solarzellen an das Hohlprofil auch bei ungünstigen Umständen ermöglicht, beispielsweise bei nicht vollkommen glatter Anlagefläche am Hohlprofil zur Aufnahme der Solarzelle.

Bei einer besonders bevorzugten Ausführungsform ist die Solarzelle an ihrer Vorderseite (also der vom Hohlprofil wegweisenden Seite) mit einer transparenten Druckplatte überspannt. Die Druckplatte ist außerdem biegesteif. Damit wird bei einer Halterung durch das Spannelement eine gleichmäßigere Anpressung der Solarzelle an das Hohlprofil über nahezu ihre gesamte Fläche hinweg erreicht. Es wird so der thermische Übergang weiter verbessert, und zwar auch dann, wenn die Aufnahmefläche am Hohlprofil nicht vollkommen glatt ist.

Bewährt hat es sich, an mindestens einem lateralen Rand (längs der Brennlinie verlaufenden Rand) außen an einem die Solarzelle tragenden Substrat eine Verbreiterung vorzusehen, die als Auflagefläche für das Spannelement fungiert. Sie ist so breit gewählt, dass unabhängig von den Lichtverhältnissen keinerlei Schattenwurf von dem Spannelement auf die aktive Fläche der Solarzelle trifft. Mit der Verbreiterung kann so zum einen eine mechanisch sehr sichere Halterung erreicht werden, zum anderen aber auch eine abschattungsfreie und damit wirkungsgradgünstige.

Es ist weiter bevorzugt, wenigstens ein Spiegelblech vorzusehen, welches als Lichtfalle für wenigstens eine Solarzelle ausgebildet ist. Die "Ausbildung als Lichtfalle" in diesem Zusammenhang bedeutet, dass das Spiegelblech so angeordnet ist, dass die im Wesentlichen senkrecht zur Oberfläche der wenigstens einen Solarzelle auf das Spiegelblech auftreffende Sonnenstrahlung auf die wenigstens eine Solarzelle umgelenkt wird.

Weiterhin können in Bereichen, in denen Solarzellen an dem Hohlprofil angeordnet sind, in der Durchleitung für das Wärmeträgerfluid des Hohlprofils Finnen vorgesehen sein. Diese Finnen sind bevorzugt stromlinienförmig ausgestaltet, sodass sich der Strömungswiderstand für das Wärmeträgerfluid im Hohlprofil möglichst wenig erhöht. Durch entsprechende Finnen wird der Wärmeübergang zwischen Hohlprofil und Wärmeträgermedium genau an den Punkten erhöht, an denen Wärme von den Solarzellen in das Hohlprofil eingetragen wird. Besonders bevorzugt ist es, wenn die Finnen diskontinuierlich angeordnet sind, und zwar in Strömungsrichtung des Wärmeträgerfluids, also längs des Hohlprofils. Zweckmäßige Ausführungen sind in Gestalt von Stacheln oder kammartig. Damit wird eine Verwirbelung der Strömung in dem Wärmeträgerfluid erreicht, wodurch sich eine bessere Wärmeübertragung zwischen Finnen und Wärmeträgerfluid ergibt. Die über den Finnen angeordneten Solarzellen werden auf diese Weise besser gekühlt.

Bei den Solarzellen kann es sich um Konzentrator-Photovoltaikzellen und/oder Thermovoltaikzellen handeln. Die Solarzellen sind vorzugsweise gegenüber dem Hohlprofil und evtl. anderer Komponenten, mit denen die Solarzellen in Kontakt stehen, elektrisch isoliert. Einzelne Solarzellen können zu Modulstreifen verbunden sein. Für einzelne oder mehrere Solarzellen oder für einzelne oder mehrere Modulstreifen können Bypass-Dioden vorgesehen sein. Die Solarzellen des Receivers können bevorzugt in Reihe geschaltet sein. Dies bietet den Vorteil, dass die durch einen Receiver erzeugte Spannung erhöht wird, womit Leitungsverluste verringert werden können.

Vorzugsweise sind zwei oder mehr der Solarzellen, die quer zur Längserstreckung des Receivers angeordnet sind, paarweise parallel geschaltet und die so gebildeten Paare wiederum in Reihe geschaltet. Die Paare umfassen jeweils zwei oder mehr Solarzellen. Durch diese kombinierte Verschaltung können effiziente Solarzellenpanels auch mit verhältnismäßig kleinen und aufgrund des Bimetalleffekts weniger zum Aufschüsseln neigenden Solarzellen gebildet werden. Bei der paarweisen Parallelschaltung verhalten sich die parallel geschalteten Solarzellen elektrisch weitgehend wie eine einzige, mehrfach große Solarzelle. Diese Parallelschaltung bietet den Vorteil, dass eine auftretende schwächere Bestrahlung einer der parallel geschalteten Solarzellen des Paares nicht zu den an sich bekannten Nachteilen bei der Verschattung von reihenverschalteten Solarzellen (Spannungsumkehr, Rückwärtsströme, Hot Spots) führt. Durch die paarweise Parallelschaltung erhöht sich somit die Robustheit. Mit der dann erfolgten Reihenschaltung werden hohe Spannungen erreicht, so dass die bei hohen Leistungen zu übertragende Stromstärke minimiert werden kann.

Den paarweise parallel geschalteten Solarzellen ist zweckmäßigerweise eine Bypassdiode zugeordnet. Sie dient dazu, evtl. ausgefallene Solarzellen zu überbrücken und damit die übergeordnete Reihenschaltung der Solarzellen weiter funktionstüchtig zu halten. Besonders bevorzugt ist, wenn die Bypassdiode auf einem gemeinsamen Substrat mit den beiden paarig parallel geschalteten Solarzellen angeordnet ist. Vorzugsweise ist die Bypassdiode gehäuselos ausgeführt, wobei sie weiter vorzugsweise durch einen zwischen Bypassdiode und Hüllrohr angebrachten und nicht mit der Bypassdiode verbundenen Reflektor geschützt ist Die Bypassdiode ist dann thermisch optimal an das Wärmeträgerfluid angekoppelt. Das bringt den Vorteil mit sich, dass die mitunter thermisch recht hoch belastete Bypassdiode auf diese Weise gut gekühlt wird, da sie Zugang zu den Kühlflächen der eigentlichen Solarzellen erhält (s. o. zusätzliche Kühlung durch Anordnung von Finnen). Einer Gefahr der Überhitzung und damit Ausfall der Bypassdiode (was in der Folge zu einem Ausfall des gesamten Paneels führen könnte), besteht somit dank dieser Anordnung nicht mehr.

Der erfindungsgemäße Receiver wird bevorzugt in einer Solaranlage eingesetzt, die ein linienförmig fokussierendes Spiegelelement umfasst, in dessen Fokuslinie ein erfindungsgemäßer Receiver derart angeordnet ist, dass die Solarzellen des Receivers dem Spiegelelement zugewandt sind. Eine entsprechende Solaranlage ist Gegenstand des nebengeordneten Anspruchs. Zur Erläuterung der Solaranlage wird auf die oben stehenden Ausführungen verwiesen.

Es ist bevorzugt, wenn die Solaranlage einen Stirling Motor, eine Organic Rankine Cycle (ORC) Anlage oder eine thermische Kältemaschine umfasst, die mit im Receiver erwärmtem Wärmeträgerfluid betrieben wird.

Die Solaranlage ist bevorzugt einachsig (hinsichtlich der Elevation) oder zweiachsig (hinsichtlich der Elevation und des Azimut) der Sonne nachführbar. Dadurch kann gewährleistet werden, dass sich der Receiver im Tagesverlauf in der Fokuslinie des linienförmig fokussierenden Spiegelelements befindet und - im Falle von optischen Konzentratorelementen im Receiver - dass sich die Solarzellen in den einzelnen Fokuspunkten befinden.

Sofern eine Solaranlage zwei Receiver oder mehr aufweist, können diese bevorzugt parallel - bspw. mit einer Tichelmann-Schaltung - angebunden sein. Dadurch kann eine gleichmäßigere Temperatur des Wärmeträgerfluid auch bei kurzzeitigen und/oder teilweisen Verschattungen, wie bspw. durch Wolken, erreicht werden.

Das Wärmeträgerfluid kann bevorzugt eine Calciumchloridlösung sein.

Die Erfindung wird nun anhand von Ausführungsbeispielen unter Bezugnahme auf die beigefügten Zeichnungen beispielhaft beschrieben. Es zeigen:
- Fig. 1: ein Ausführungsbeispiel einer erfindungsgemäßen Solaranlage;
- Fig. 2: ein erstes Beispiel eines Receivers außerhalb des Schutzbereiches der Anprüche;
- Fig. 3: ein Ausführungsbeispiel eines erfindungsgemäßen Receivers, wobei das Klemmelement nicht im Detail dargestellt ist;
- Fig. 4: ein zweites Beispiel eines Receivers mit einem Strahlteiler außerhalb der Ansprüche;
- Fig. 5: ein weiteres Ausführungsbeispiel eines erfindungsgemäßen Receivers;
- Fig. 6: ein Beispiel eines Receivers außerhalb der Ansprüche;
- Fig. 7a-c: Detaildarstellungen zu Finnen im Hohlprofil;
- Fig. 8a-b: Seitenansicht und Aufsicht auf eine Solarzelle mit paralleler und reihenartiger Verschaltung; und
- Fig. 9: eine Detaildarstellung zur festen Anordnung von Hohlprofil, Zelle und strahlmanipulierendem Element.

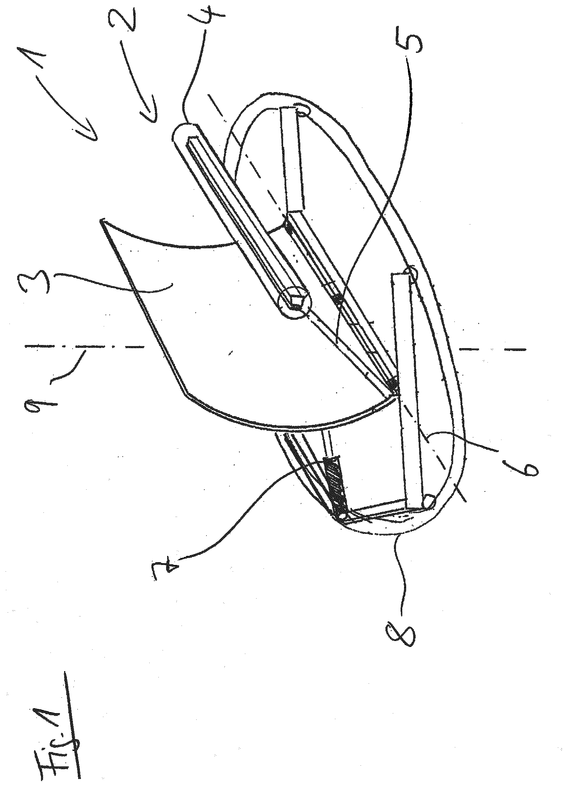

In Figur 1 ist eine erfindungsgemäße Solaranlage 1 dargestellt. Die Solaranlage 1 umfasst eine Kollektoreinheit 2 mit einem linienförmig fokussierenden Spiegelelement 3 und einem langgestreckten Receiver 4. Der Receiver 4 ist entlang der Fokuslinie des linienförmig fokussierenden Spiegelelements 3 angeordnet und wird dort mithilfe von Tragarmen 5 gehalten.

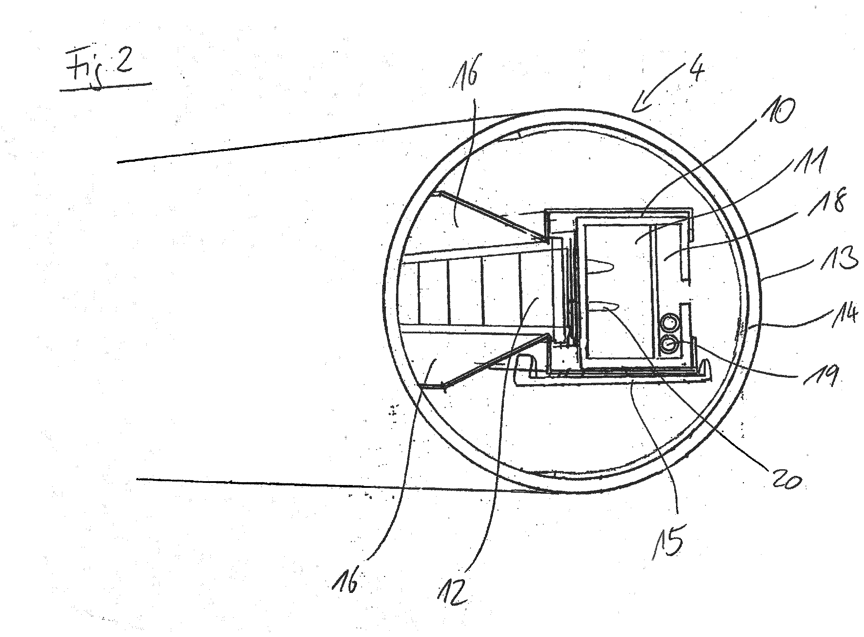

Bei dem linienförmig fokussierenden Spiegelelement 3 handelt es sich um eine halbparaboloide Spiegelrinne. Der Receiver 4 ist ein erfindungsgemäßer Receiver 4, der ähnlich den Figuren 2, 3 oder 4 ausgestaltet sein kann. Die Ausgestaltung des Receivers 4 wird anhand dieser Figuren später erläutert.

Die Kollektoreinheit 2 umfassend das linienförmig fokussierende Spiegelelement 3 und den Receiver 4 ist um eine Schwenkachse 6 schwenkbar gelagert, wobei die Schwenkachse 6 entlang einer Kante des linienförmig fokussierenden Spiegelelements 3 verläuft. Über ein Antriebselement 7 lässt sich die Kollektoreinheit 2 um die Schwenkachse 6 verschwenken. Die Kollektoreinheit 2 lässt sich so hinsichtlich der Elevation dem Stand der Sonne nachführen.

Die Kollektoreinheit 2 ist weiterhin auf einem Drehwerk 8 angeordnet. Mithilfe dieses Drehwerkes 8 lässt sich die Kollektoreinheit 2 um eine Achse 9 senkrecht zu der Schwenkachse 5 der Kollektoreinheit 2 drehen. Durch das Verschwenken der Kollektoreinheit 2 einerseits und das Drehen derselben um die Drehachse des Drehwerks 8 andererseits wird eine zweiachsige Nachführung erreicht, nämlich hinsichtlich der Elevation und des Azimut.

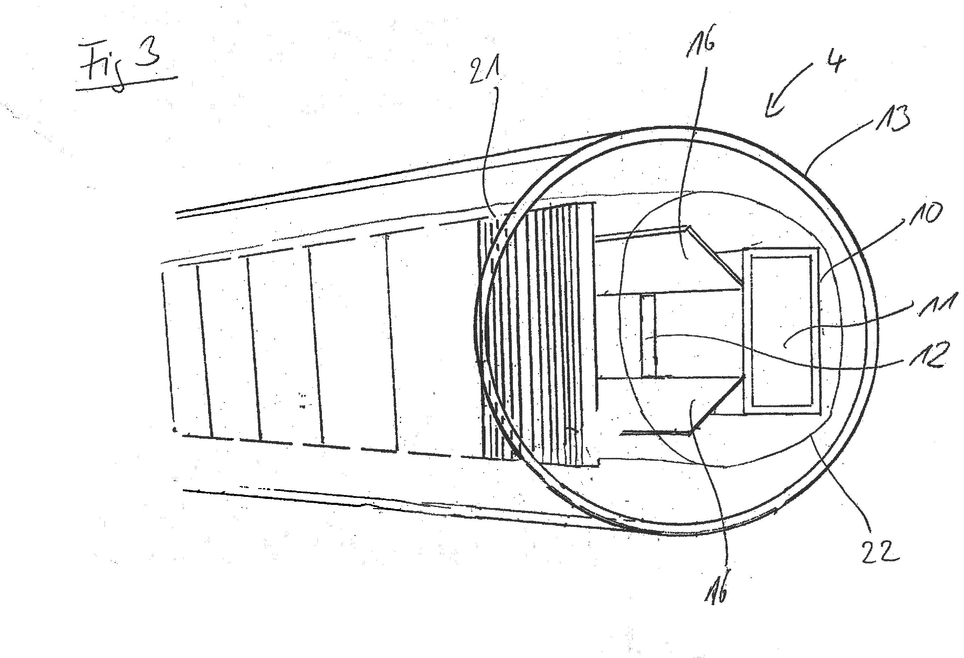

In Figur 2 ist ein erstes Beispiel eines Receivers 4 gezeigt, wie er in einer Solaranlage 1 aus Figur 1 verwendet werden kann. Der Receiver 4 umfasst ein langgestrecktes Hohlprofil 10, welches eine Durchleitung 11 für ein Wärmeträgerfluid, bspw. eine Calciumchloridlösung, aufweist. Auf einer Seite des Hohlprofils 10 sind Solarzellen 12 angeordnet. Mit diesen Solarzellen 12 kann Sonnenstrahlung in elektrische Energie umgewandelt werden. Bei einer Verwendung des Receivers 4 aus Figur 2 in einer Solaranlage 1 nach Figur 1 sind die Solarzellen 12 dem linienförmig fokussierenden Spiegelelement 3 zugewandt und entlang dessen Fokuslinie angeordnet. In dem Strahlengang zwischen dem Spiegelelement 3 und den Solarzellen 12 ist ein strahlmanipulierendes Element (in Fig. 2 nicht dargestellt, vgl. Fig. 3) angeordnet. Außerdem sind die Solarzellen 12 in Reihe geschaltet.

Die Solarzellen 12 sind wärmeleitend mit dem Hohlprofil 10 verbunden. Die Wärme, die neben der elektrischen Energie an den Solarzellen 12 anfällt, kann dann über das Hohlprofil 10 dem Wärmeträgerfluid in der Durchleitung 11 zugeführt werden. Die im Wärmeträgerfluid gespeicherte Wärme kann dann außerhalb des Receivers 4 genutzt werden, bspw. in einem Stirlingmotor oder einer ORC-Anlage.

Die Anordnung aus Hohlprofil 10 und Solarzellen 12 ist in einem transparenten Hüllrohr 13 angeordnet. Im dargestellten Ausführungsbeispiel ist das Hüllrohr 13 aus Glas und vakuumiert. Es wird so eine gute Wärmeisolierung des Hohlprofils 10 gegenüber der Umgebung erreicht. Außerdem kann die Außenseite des Hohlprofils 10 leicht gereinigt werden.

Auf der von den Solarzellen 12 abgewandten Seite des Hohlprofils 10 ist an der Innenseite des Hüllrohrs 13 ein Reflektor 14 angeordnet. Der Reflektor 14 besteht aus einer mehrlagigen Metallfolie. Mit diesem Reflektor 14 wird die vom Hüllrohr 13 abgestrahlte Wärmestrahlung auf diese zurück reflektiert. Die Wärmeverluste können so weiter reduziert werden.

Um einen guten Wärmeübergang zwischen Solarzellen 12 und Hohlprofil 10 zu gewährleisten, sind die Solarzellen 12 zu Modulplatten zusammengefügt, wobei zumindest eine Solarzelle 12 einer solchen Modulplatte mit einem Klemmelement 15 aus Federstahl an das Hohlprofil 10 angepresst wird. Aufgrund der mechanischen Verbindung zwischen den einzelnen Solarzellen 12 der Modulplatten werden auch die benachbarten Solarzellen 12 an das Hohlprofil 10 angepresst. Zwischen den Solarzellen 12 und dem Hohlprofil 10 ist außerdem Wärmeleitpaste vorgesehen, wodurch der Wärmeübergang weiter verbessert wird.

Weiterhin sind Spiegelbleche 16 vorgesehen, die als Lichtfalle für die Solarzellen 12 wirken. Auf den Receiver 4 fokussierte Sonnenstrahlung, die auf diese Spiegelbleche 16 auftrifft, wird auf die Solarzellen 12 umgelenkt und kann dort in elektrische Energie umgewandelt werden. Die Spiegelbleche 16 ermöglichen es also, Ungenauigkeiten in der Positionierung des Receivers, der Nachführung etc. auszugleichen, indem sie Sonnenstrahlung, welche nicht direkt auf die Solarzellen 12 gebündelt ist, auf diese umlenken.

Die Spiegelbleche 16 können auch einstückig mit einem Klemmelement 15 ausgebildet sein.

Auf der von den Solarzellen 12 abgewandten Seite des Hohlprofils 10 ist eine Kabelführung 18 vorgesehen. In dieser Kabelführung 18 sind die elektrischen Kabel 19 zur Anbindung der Solarzellen 12 angeordnet. Auch können in der Kabelführung 18 Bypass-Dioden für die Solarzellen 12 angeordnet sein.

Auf der Innenseite des Hohlprofils 10 sind an den Stellen, an denen die Solarzellen 12 Wärme in das Hohlprofil 10 eintragen, Finnen 20 vorgesehen. Die Finnen 20 sind strömungsgünstig ausgebildet und werden vom Wärmeträgerfluid umströmt, womit der Wärmeübergang vom Hohlprofil 10 auf das Wärmeträgerfluid weiter verbessert werden kann.

In Figur 3 ist ein Ausführungsbeispiel eines erfindungsgemäßen Receivers 4 dargestellt. Der Receiver 4 aus Figur 3 lässt sich ebenfalls in einer Solaranlage 1 gemäß Figur 1 verwenden. Bei dem Ausführungsbeispiel aus Figur 3 tragen mit dem Ausführungsbeispiel aus Figur 2 vergleichbare Elemente dieselben Bezugsziffern. Zur Erläuterung dieser Elemente wird auch auf die Ausführungen zu Figur 2 verwiesen.

Der Receiver 4 aus Figur 3 umfasst ein in einem Hüllrohr 13 angeordnetes langgestrecktes Hohlprofil 10 mit einer Durchleitung 11 für ein Wärmeträgerfluid. Auf einer Seite des Hohlprofils 10 und damit ebenfalls im Hüllrohr 13 sind Solarzellen 12 angeordnet. Mit diesen Solarzellen 12 kann Sonnenstrahlung in elektrische Energie umgewandelt werden. Die dabei auftretende Wärme kann über ein Wärmeträgerfluid, welches durch das Hohlprofil 10 strömt, abgeführt und genutzt werden.

Die Solarzellen 12 sind Konzentrator-Photovoltaikzellen, die nicht kontinuierlich entlang des Hohlprofils 10, sondern an diskreten Punkten desselben angeordnet sind. Um bspw. durch eine Solaranlage 1 gemäß Figur 1 linienförmig auf den Receiver 4 gebündelte Sonnenstrahlung auf die Solarzellen 12 zu bündeln, sind als strahlmanipulierende Elemente Konzentratorelemente 21 vorgesehen. Bei den Konzentratorelementen 21 handelt es sich um lineare Fresnellinsen, welche die linienförmig gebündelt auf den Receiver 4 auftreffende Sonnenstrahlung abschnittsweise auf jeweils eine Solarzelle 12 weiter fokussieren.

Am Hohlprofil 10 sind Spiegelbleche 16 vorgesehen, die als Lichtfalle für die Solarzellen 12 wirken. Nicht direkt auf die Solarzellen 12 gebündelte Sonnenstrahlung kann auf die Solarzellen 12 umgelenkt werden. Die Solarzellen 12 weisen jeweils eine Bypass-Diode (nicht dargestellt) auf.

Das Hohlprofil 10 ist zusammen mit den Solarzellen und den Spiegelblechen 16 in einer schlauchförmigen transparenten Folie 22 angeordnet, die wiederum vollständig im Hüllrohr 13 angeordnet ist. An ihren Enden liegt die schlauchförmige transparente Folie 22 dichtend am Hohlprofil 10 an, sodass der Bereich zwischen Hohlprofil 10 und Folie 22 dicht abgeschlossen ist. In dem genannten Bereich zwischen Hohlprofil 10 und Folie 22 herrscht im Betrieb ein größerer Druck als im Bereich zwischen Folie 22 und Hüllrohr 13, sodass die schlauchförmige transparente Folie 22 weitestgehend formstabil zwischen Hohlprofil 10 und Hüllrohr 13 angeordnet bleibt. Aufgrund der Folie 22 können Wärmeverluste aufgrund von Konvektion reduziert werden.

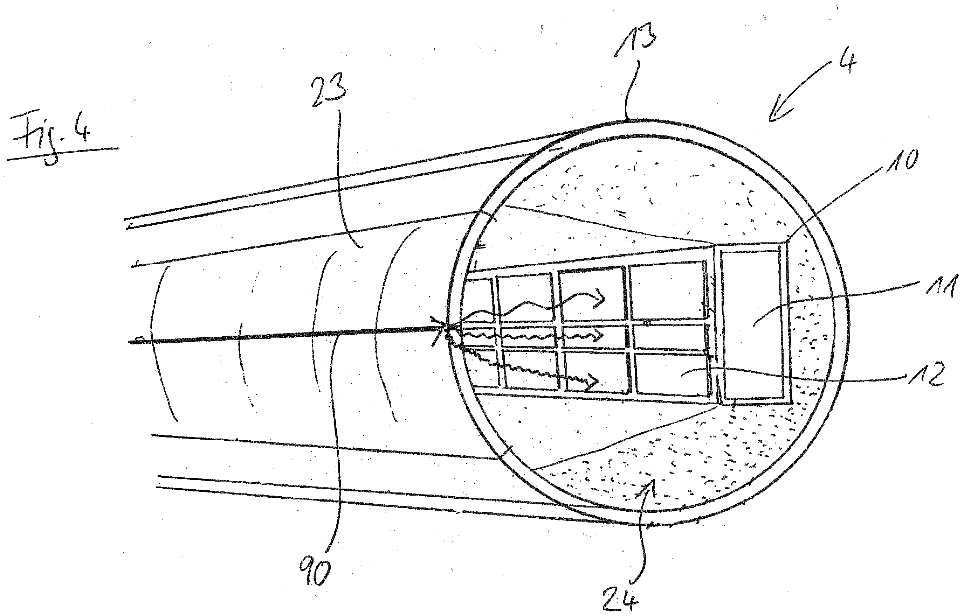

In Figur 4 ist ein weiteres Beispiel eines Receivers 4 dargestellt. Dieser Receiver 4 lässt sich ebenfalls in einer Solaranlage gemäß Figur 1 verwenden. Bei dem Beispiel aus Figur 4 tragen mit dem Beispiel aus Figur 2 und dem Ausführungsbeispiel aus Figur 3 vergleichbare Elemente dieselben Bezugsziffern. Zur Erläuterung dieser Elemente wird daher auch auf die obigen Ausführungen verwiesen.

Beim Receiver 4 aus Figur 4 ist innerhalb eines Hüllrohres 13 ein Hohlprofil 10 mit darauf angebrachten Solarzellen 12 angeordnet. Das Hohlprofil 10 weist dabei eine Durchleitung 11 für ein Wärmeträgerfluid auf, welches der Abführung und Nutzbarmachung von an den Solarzellen 12 entstehender Wärme dient.

Die Solarzellen 12 sind jeweils für unterschiedliche Wellenlängen der Sonnenstrahlung optimiert. Damit die einzelnen Solarzellen 12 mit möglichst optimalem Strahlungsspektrum betrieben werden, ist in der Wand des Hüllrohrs 10 ein Strahlteiler 23 eingearbeitet, der die auf den Strahlteiler auftreffende, bspw. in einer Solaranlage 1 gemäß Figur 1 linienförmig gebündelte Sonnenstrahlung entsprechend der Wellenlänge aufteilt und auf die jeweiligen Wellenlängen optimierte Solarzellen 12 umlenkt. Dies wird durch den beispielhaft dargestellten Strahlengang 90 verdeutlicht.

Der Bereich zwischen Hüllrohr 13 und Hohlprofil 10 ist mit Aerogel 24 ausgefüllt. Dabei ist das Aerogel 24 im Bereich zwischen Strahlteiler 23 und Solarzellen 12 - d. h. in dem Bereich des Strahlengangs der linienförmig gebündelten Sonnenstrahlung - transparent, während im übrigen Bereich Einlagerungen aus Trübungsstoffen vorgesehen sind. Die Einlagerungen aus Trübungsstoffen dienen der Reflektion der vom Hohlprofil 10 abgestrahlten Wärmestrahlung auf das Hohlprofil 10 zurück. Wärmeverluste können so reduziert werden.

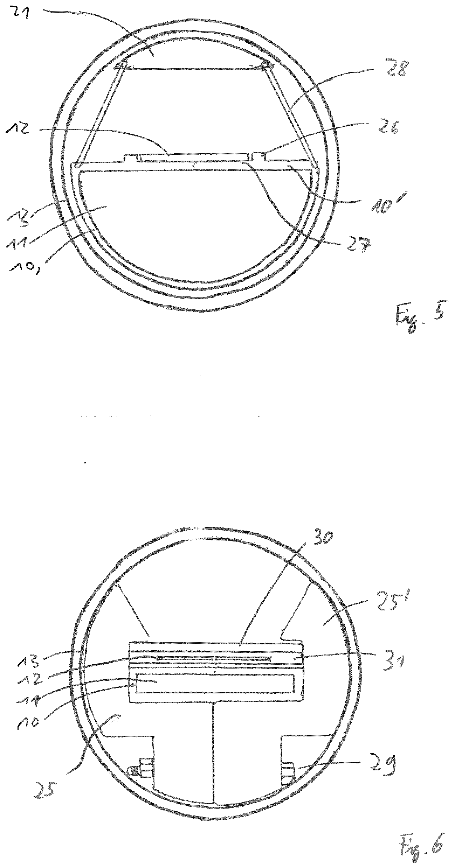

In Figur 5 ist ein weiteres Ausführungsbeispiel eines erfindungsgemäßen Receivers 4 dargestellt. Dieser Receiver 4 lässt sich ebenfalls in einer Solaranlage gemäß Figur 1 verwenden. Bei dem Ausführungsbeispiel aus Figur 5 tragen mit dem Ausführungsbeispiel aus Figur 3 vergleichbare Elemente dieselben Bezugsziffern. Zur Erläuterung dieser Elemente wird daher auch auf die obigen Ausführungen verwiesen.

Beim Receiver 4 gemäß Figur 5 ist das Hohlprofil 10 halbzylindrisch ausgeführt. In dem dargestellten Ausführungsbeispiel ist es exakt halbzylindrisch, d. h. die von der Sekante des Halbzylinders gebildete ebene Deckfläche 10' zur Aufnahme der Solarzellen 12 läuft durch den Mittelpunkt des Halbzylinders. Es ist auch möglich, die Deckfläche nach unten oder oben zu versetzen, wodurch das Hohlprofil eine im Querschnitt hufeisenförmige Gestalt erhält. Auf der Deckfläche 10' sind zwei parallel verlaufende Leisten 26 vorgesehen. Sie bilden zwischen sich eine Aufnahmetasche 27 für die Solarzellen 12. Ferner ist oben auf dem Hohlprofil 10 eine Halterung 28 für die als optisches Konzentratorelement fungierenden Fresnellinsen 21 angeordnet. Es ergibt sich so eine besonders kompakte und steife Konstruktion mit fester Positionierung der Fresnellinse 21, die zudem einfach im Hinblick auf Herstellung und Montage ist.

In Figur 6 ist ein weiteres Beispiel eines Receivers 4 dargestellt. Dieser Receiver 4 lässt sich ebenfalls in einer Solaranlage gemäß Figur 1 verwenden. Bei dem Beispiel aus Figur 6 tragen mit den Beispielen aus Figur 2 bis 5 vergleichbare Elemente dieselben Bezugsziffern. Zur Erläuterung dieser Elemente wird daher auch auf die obigen Ausführungen verwiesen.

Das Hohlprofil 10 ist bei diesem Beispiel mittels Haltescheiben 25 in dem Hüllrohr 13 gehaltert. Die Haltescheiben 25 sind zweiteilig ausgeführt. Im montierten Zustand sind die Hälften der Haltescheiben 25 auf die Lateralseiten des Hohlprofils 10 aufgesteckt und mittels einer Verschraubung 29 gesichert. Die Haltescheiben 25 sind mit ihrer Außenkontur an die Innenwandung des Hüllrohrs 13 angepasst und fixieren somit positionsgenau das Hohlprofil 10 in dem Hüllrohr. Im oberen Bereich weisen die Haltescheiben 25 einen kreissegmentartigen Ausschnitt auf. Er sorgt für einen freien Strahlengang der durch das Hüllrohr 13 einfallenden Licht- und Wärmestrahlung auf die Solarzellen 12 und das Hohlprofil 10.

Die Haltescheiben 25 umfassen mit ihrem oberen, an den Ausschnitt grenzenden Bereich 25' fingerartig die Oberseite des Hohlprofils 10. Die Abmessungen sind so gewählt, dass eine Presspassung zum Hohlprofil entsteht, somit fungieren die oberen Bereiche der Haltescheiben als Klemmelement für die Solarzellen 12. Ferner ist eine Glasscheibe als transparente Druckplatte 30 vorgesehen, welche auf der Solarzelle 12 aufliegt und deren Vorderseite überspannt. Sie wird von den Klemmelementen, hier in Gestalt der fingerartigen Bereiche 25' der Haltescheiben 25, auf die Solarzelle 12 gepresst und diese auf das Hohlprofil 10 gepresst, wodurch für einen guten und sicheren Wärmeübergang zwischen Solarzelle 12 und Hohlprofil 10 gesorgt wird. Zur Vermeidung von Spannungen ist vorzugsweise zwischen Druckplatte 30 und Solarzelle 12 eine gleichfalls transparente Vergussmasse 31 vorgesehen. Es sei angemerkt, dass die transparente Druckplatte 30 nicht auf dieses Ausführungsbeispiel beschränkt ist, sondern auch bei den anderen vorgesehen sein kann.

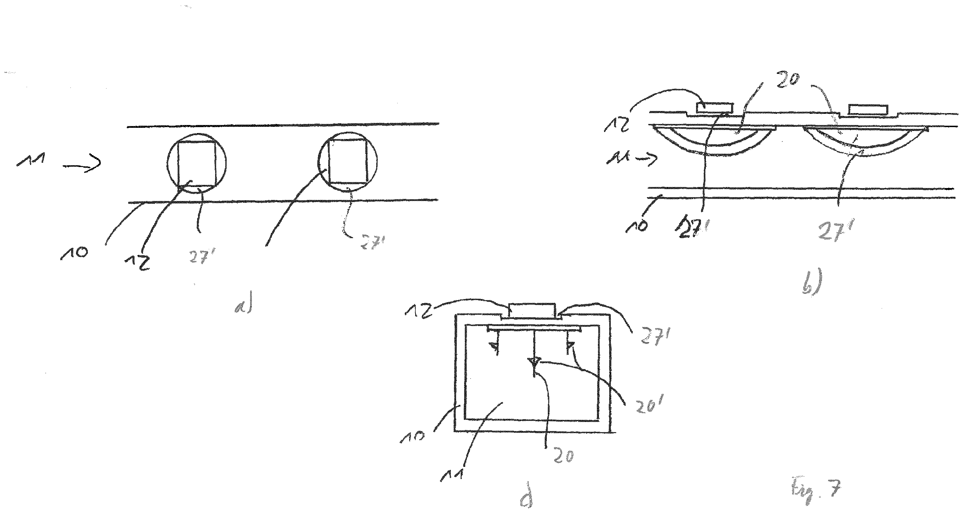

In Figur 7a-c sind weitere Details und Ausführungsbeispiele für die Finnen 20 dargestellt. In Figur 7a ist am Beispiel des in Figur 3 dargestellten Ausführungsbeispiels eine Aufsicht auf das Hohlprofil 10 dargestellt, während Fig. 7b einen Längsschnitt und Fig. 7c einen Querschnitt durch das Hohlprofil 10 zeigt. Man erkennt die Solarzellen 12, die in kreisrunden Aussparungen 27' angeordnet sind. Die Finnen 20 sind als Kreisbogensegmente ausgeführt und ragen kammartig an Positionen unterhalb der jeweiligen Solarzellen 12 nach unten in den Innenraum des Hohlprofils 10 hinein. Die Finnen 20 sind in Strömungsrichtung des Wärmeträgerfluids 11 gesehen diskontinuierlich angeordnet. Zwischen ihnen bestehen Bereiche ohne Finnen. Ferner weisen die Finnen 20 in ihren Endbereichen seitliche Hervorstehungen 20' auf. Das durch diesen Innenraum strömende Wärmeträgerfluid 11 wird durch die diskontinuierlich angeordneten Finnen 20 verwirbelt. Ferner wird durch die seitlichen Hervorstehungen 20' eine zusätzliche Turbulenz erzeugt. Damit ergibt sich eine Durchmischung des Wärmeträgerfluids 11, was für eine deutlich verbesserte Wärmeübertragung und - abfuhr verglichen mit der sich herkömmlicherweise einstellenden laminaren Strömung sorgt. Durch die somit verbesserte Wärmeabfuhr wird sowohl der Wirkungsgrad gesteigert, wie auch eine bessere Kühlung der Solarzellen 12 erreicht. Es versteht sich, dass die Finnen 20 auch bei anderen Ausführungsformen vorgesehen sein können.

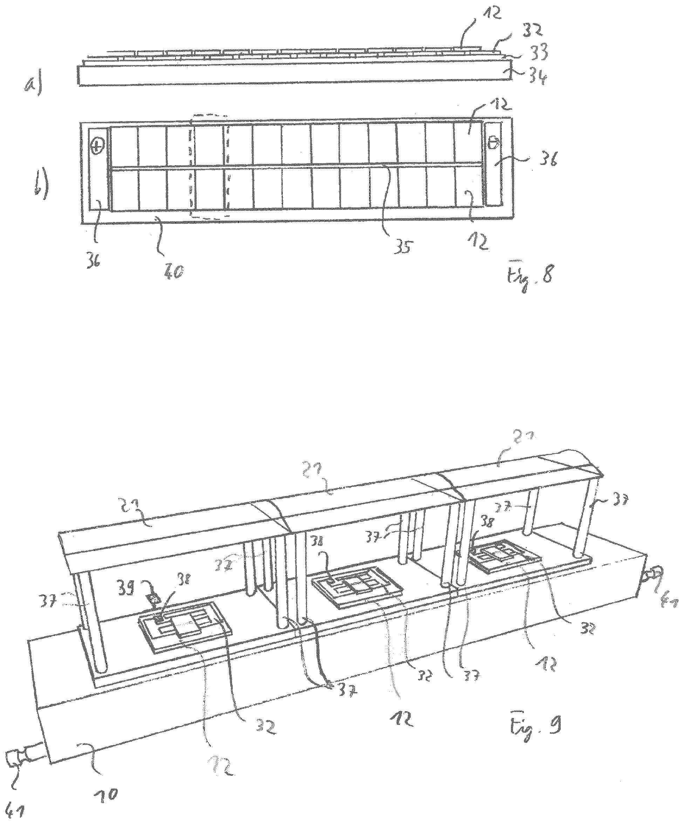

In Figur 8 a, b ist eine Lateralansicht sowie eine Aufsicht auf ein Panel mit mehreren Solarzellen 12 dargestellt. Die Solarzellen 12 sind auf einer aus Kupfermaterial bestehenden Leitstruktur 32 angeordnet. Sie sorgt für eine elektrische Kontaktierung der Solarzellen 12 und für eine günstige Wärmeübertragung zur Kühlung. Die Leitstruktur 32 ist über einer dünnen Isolierschicht 33 auf einem Substrat 34 angeordnet, das vorzugsweise aus einem thermisch gut leitenden Metall, wie Kupfer oder Aluminium, oder einem hitzefesten Keramikmaterial besteht.

Die Solarzellen 12 sind in Doppelreihe auf der Grundplatte 34 angeordnet, mit einem Trennsteg 35 zwischen den Reihen. Es sind jeweils eine Solarzelle 12 oberhalb des Trennstegs 35 und die ihr unmittelbar gegenüber liegende unterhalb des Trennstegs 35 zu je einem Paar zusammengefasst (s. gestrichelte Linie in Figur 8b). Die jeweils ein Paar bildenden Solarzellen (hier zwei) sind elektrisch parallel geschaltet, während die Paare über die Länge des Solarpanels hinweg in Reihe geschaltet sind. Zum elektrischen Anschluss ist somit an jedem Ende ein Anschlusspol 36 vorgesehen. Dank der Parallelschaltung in Paaren ergibt sich eine große Verschattungstoleranz. Damit kann auch aus verhältnismäßig kleinen Solarzellen, die kostengünstig herzustellen und einfach zu verarbeiten bzw. montieren sind, ein wirksames großes Solarpanel gebildet werden. Das Solarpanel weist an mindestens einer Lateralseite eine Verbreiterung 40 auf. Sie dient als Auflagefläche für das Klemmelement 15 bzw. dessen Finger 25' zur besseren Anpressung auf das Hohlprofil 10.

In Figur 9 ist die feste Anordnung von Hohlprofil, Zelle und strahlmanipulierendem Element (Fresnellinse 21) dargestellt. Die dargestellten drei Fresnellinsen 21 sind aufgeständert auf mehreren Säulen 37, die mit ihrem Fuß auf dem Hohlprofil 10 angeordnet sind. Es sind drei Konzentrator-Solarzellen vorgesehen, die jeweils ein Paar Solarzellen 12 in Parallelschaltung aufweisen. Für jedes dieser Paare Solarzellen 12 ist eine Bypass-Diode 38 vorgesehen. Sie ist dazu ausgebildet, bei ungleichmäßiger Bestrahlung der beiden Solarzellen 12 eine Rückstrombelastung der schwächer angestrahlten Solarzelle 12 zu verhindern. Zur sicheren Abführung dabei entstehender thermischer Verlustleistung ist die Bypassdiode 38 auf demselben Trägersubstrat angeordnet wie das Paar Solarzellen 12. Vorzugsweise ist die Bypassdiode dazu ohne Gehäuse aufgebracht. Zum Schutz vor Lichteinstrahlung kann eine Abdeckung 39 vorgesehen sein oder die Bypassdiode wird abseits vom Fokus angeordnet, wo nur mit geringer Bestrahlung (Streulicht) gerechnet zu werden braucht. Damit ergibt sich eine kompakte und robuste Anordnung.

## Patentansprüche

1. Receiver (4) für die Anordnung in der Fokuslinie eines Solarkollektors (1) mit einem linienförmig fokussierenden Spiegelelement (3), wobei der Receiver ein langgestrecktes Hohlprofil (10) mit einer Durchleitung (11) für Wärmeträgerfluid und auf einer Seite des Hohlprofils (10) angeordnete Solarzellen (12) zur Umwandlung von Sonnenstrahlung in elektrische Energie umfasst, wobei die Solarzellen (12) und das Hohlprofil (10) wärmeleitend verbunden sind, wobei mindestens ein strahlmanipulierendes Element entlang des Hohlprofils (10) angeordnet ist und wobei als strahlmanipulierendes Element Konzentratorelemente (21) zum Bündeln von linienförmig fokussiert auf den Receiver (4) auftreffender Sonnenstrahlung in einzelne Fokuspunkte entlang der Fokuslinie vorgesehen sind, **dadurch gekennzeichnet, dass** das Hohlprofil (10) mit den darauf angeordneten Solarzellen (12) in einem transparenten Hüllrohr (13) in der Weise angeordnet ist, dass die Konzentratorelemente (21) zwischen Hüllrohr (13) und den Solarzellen (12) angeordnet sind und die Lage von Hohlprofil, Solarzellen (12), Hüllrohr (13) und den Konzentratorelementen (21) zueinander fest ist, und dass wenigstens ein Spannelement vorgesehen ist, welches das Hohlprofil (10) und wenigstens eine Solarzelle (12) derart umgreift, dass die wenigstens eine Solarzelle (12) an das Hohlprofil (10) angepresst wird.

2. Receiver nach Anspruch 1, **dadurch gekennzeichnet, dass** als strahlmanipulierendes Element ein Strahlteiler (23) vorgesehen ist, der die einfallende Sonnenstrahlung in verschiedene Wellenlängen aufspaltet und jeweils auf bezüglich der verschiedenen Wellenlängen optimierte Solarzellen (12) umlenkt.

3. Receiver nach einem der Ansprüche 1 bis 2, **dadurch gekennzeichnet, dass** der Bereich zwischen Hohlprofil (10) und Hüllrohr (13) vakuumiert oder mit Edelgas gefüllt ist.

4. Receiver nach einem der vorhergehenden Ansprüche, **dadurch gekennzeichnet, dass** an beiden Enden des Hüllrohrs (13) Anschlüsse (41) zum Spülen mit Gas vorgesehen sind.

5. Receiver nach einem der vorhergehenden Ansprüche, **dadurch gekennzeichnet, dass** auf der von den Solarzellen (12) abgewandten Seite des Hohlprofils (10) zwischen Hohlprofil (10) und Hüllrohr (13) ein Reflektor vorgesehen ist, um die vom Hohlprofil (10) stammende Wärmestrahlung und/oder Leckstrahlung vom strahlmanipulierenden Element auf das Hohlprofil (10) zurückzuwerfen.

6. Receiver nach einem der vorhergehenden Ansprüche, **dadurch gekennzeichnet, dass** das wenigstens eine strahlmanipulierende Element einstückig mit dem Hüllrohr (13) ausgebildet ist.

7. Receiver nach einem der vorhergehenden Ansprüche, **dadurch gekennzeichnet, dass** eine thermische Längenausdehnung des Hohlprofils (10) so eingestellt ist, dass sie betragsmäßig etwa gleich zu derjenigen des Hüllrohrs (13) ist.

8. Receiver nach einem der vorhergehenden Ansprüche, **dadurch gekennzeichnet, dass** das Hohlprofil (10) halbzylindrisch oder hufeisenförmig ausgebildet ist.

9. Receiver nach einem der vorhergehenden Ansprüche, **dadurch gekennzeichnet, dass** mindestens eine Haltescheibe (25) zur Positionierung des Hohlprofils (10) in dem Hüllrohr (13) vorgesehen ist, deren Außenkontur an die Innenwandung des Hüllrohrs (13) angepasst ist.

10. Receiver nach einem der vorhergehenden Ansprüche, **dadurch gekennzeichnet, dass** am Hohlprofil (10) Vertiefungen (27) oder Erhöhungen (26) zur formschlüssigen Aufnahme der Solarzellen (12) ausgebildet sind.

11. Receiver nach einem der vorhergehenden Ansprüche, **dadurch gekennzeichnet, dass** das wenigstens eine Spannelement in Gestalt eines Klemmelements (16) vorgesehen ist.

12. Receiver nach Anspruch 11, **dadurch gekennzeichnet, dass** das Spannelement in seinem auf der Solarzelle (12) wirkenden Bereich mehrere Finger (25') aufweist, mit denen es die Solarzelle (12) gegen das Hohlprofil (10) drückt.

13. Receiver nach Anspruch 11 oder 12, **dadurch gekennzeichnet, dass** zwischen Spannelement und Solarzelle (12) eine transparente und biegesteife Druckplatte (30) angeordnet ist, welche eine Vorderfläche der Solarzelle (12) überspannt.

14. Receiver nach einem der vorhergehenden Ansprüche, **dadurch gekennzeichnet, dass** eine Verbreiterung (40) außen an wenigstens einem lateralen Rand eines die Solarzelle (12) tragenden Substrats vorgesehen ist, wobei die Verbreiterung (40) so ausgebildet ist, dass sie eine nicht-verschattende Auflagefläche für das Spannelement bildet.

15. Receiver nach einem der vorhergehenden Ansprüche, **dadurch gekennzeichnet, dass** in den Bereichen, in denen Solarzellen (12) an dem Hohlprofil (10) angeordnet sind, in der Durchleitung (11) für das Wärmeträgerfluid des Hohlprofils (10) Finnen (20) vorgesehen sind.

16. Receiver nach Anspruch 15, **dadurch gekennzeichnet, dass** die Finnen (20) diskontinuierlich entlang der Strömungsrichtung des Wärmeträgerfluids in der Durchleitung (11) angeordnet sind.

17. Receiver nach einem der vorhergehenden Ansprüche, **dadurch gekennzeichnet, dass** die Solarzellen (12) Konzentrator-Photovoltaikzellen und/oder Thermovoltaikzellen sind.

18. Receiver nach einem der vorhergehenden Ansprüche, **dadurch gekennzeichnet, dass** die zwei oder mehr Solarzellen (12), die quer zur Längserstreckung des Receivers angeordnet sind, paarweise parallel und diese Paare in Reihe geschaltet sind, wobei ein solches Paar zwei oder mehr Solarzellen umfasst.

19. Receiver nach Anspruch 18, **dadurch gekennzeichnet, dass** für je ein Paar der Solarzellen (12) eine Bypassdiode (38) vorgesehen ist.

20. Receiver nach Anspruch 19, **dadurch gekennzeichnet, dass** die Bypassdiode (38) auf einem gemeinsamen Substrat mit dem Paar des Solarzellen (12) angeordnet ist, wobei die Bypassdiode (38) gehäuselos ausgeführt und durch einen zwischen Bypassdiode (38) und Hüllrohr (13) angebrachten und nicht mit der Bypassdiode (38) verbundenen Reflektor (39) geschützt ist.

21. Solaranlage (1) mit einem linienförmig fokussierenden Spiegelelement (3), in dessen Fokuslinie ein Receiver (4) angeordnet ist, wobei der Receiver (4) nach einem der Ansprüche 1 bis 20 ausgebildet und derart angeordnet ist, dass die Solarzellen (12) des Receivers (4) dem linienförmig fokussierenden Spiegelelement (3) zugewandt sind.

22. Solaranlage nach Anspruch 21, **dadurch gekennzeichnet, dass** die Solaranlage (1) einen Stirlingmotor, eine Organic Rankine Cycle (ORC) Anlage oder eine thermische Kältemaschine umfasst, die mit im Receiver (4) erwärmten Wärmeträgerfluid betrieben wird.

23. Solaranlage nach Anspruch 21 oder 22, **dadurch gekennzeichnet, dass** die Solaranlage (1) einachsig oder zweiachsig nachführbar ist.

## Claims

1. A receiver (4) for arrangement in the focal line of a solar collector (1) having a linearly focusing mirror element (3), the receiver comprising an elongate hollow profile (10) having a duct (11) for a heat transfer fluid and having solar cells (12), arranged on one side of the hollow profile (10), for converting solar radiation into electrical energy, the solar cells (12) and the hollow profile (10) being connected in a thermally conductive manner, at least one beam-manipulating element being arranged along the hollow profile (10) and concentrator elements (21) for concentrating solar radiation, that is incident upon the receiver (4) in a linearly focused manner, into individual focal points along the focal line, being provided as the beam-manipulating element, **characterized in that** the hollow profile (10), having the solar cells (12) arranged thereon, is arranged in a transparent casing tube (13) in such a manner that the concentrator elements (21) are arranged between the casing tube (13) and the solar cells (12), and the relative position of the hollow profile, solar cells (12), casing tube (13) and beam-manipulating elements (21) is fixed, and that at least one tensioning element is provided, which grips around the hollow profile (10) and at least one solar cell (12) in such a manner that the at least one solar cell (12) is pressed to the hollow profile (10).

2. The receiver as claimed in claim 1, **characterized in that** a beam splitter (23), which splits the incident solar radiation into differing wavelengths and deflects it, respectively, onto solar cells (12) optimized in respect of the differing wavelengths, is provided as a beam-manipulating element.

3. The receiver as claimed in one of claims 1 to 2, **characterized in that** the region between the hollow profile (10) and the casing tube (13) is vacuumed or filled with inert gas.

4. The receiver as claimed in one of the preceding claims, **characterized in that** connections (41) for flushing with gas are provided at both ends of the casing tube (13).

5. The receiver as claimed in one of the preceding claims, **characterized in that** on the side of the hollow profile (10) that faces away from the solar cells (12) a reflector is provided between the hollow profile (10) and the casing tube (13), in order to reflect the thermal radiation and/or leakage radiation originating from the hollow profile (10), from the beam-manipulating element back onto the hollow profile (10).

6. The receiver as claimed in one of the preceding claims, **characterized in that** the at least one beam-manipulating element is integral with the casing tube (13).

7. The receiver as claimed in one of the preceding claims, **characterized in that** a linear thermal expansion of the hollow profile (10) is set such that it is approximately equal in amount to that of the casing tube (13).

8. The receiver as claimed in one of the preceding claims, **characterized in that** the hollow profile (10) is semi-cylindrical or horseshoe-shaped.

9. The receiver as claimed in one of the preceding claims, **characterized in that** for positioning the hollow profile (10) in the casing tube (13) at least one holding disk (25) is provided, the outer contour of which is matched to the inner wall of the casing tube (13).

10. The receiver as claimed in one of the preceding claims, **characterized in that** recesses (27) or protuberances (26), for receiving the solar cells (12) in a form-fitting manner, are realized on the hollow profile (10).

11. The receiver as claimed in one of the preceding claims, **characterized in that** the at least one tensioning element is provided in the form of a clamping element (16).

12. The receiver as claimed in claim 11, **characterized in that** the tensioning element, in the region thereof that acts on the solar cell (12), has a plurality of fingers (25'), by means of which it presses the solar cell (12) against the hollow profile (10).

13. The receiver as claimed in claim 11 or 12, **characterized in that** between the tensioning element and the solar cell (12) a transparent and rigid pressure plate (30) is arranged that spans a front face of the solar cell (12).

14. The receiver as claimed in one of the preceding claims, **characterized in that** there is a widened portion (40) provided on the outside of at least one lateral edge of a substrate that carries the solar cell (12), wherein the widened portion (40) is designed such that it forms a non-shading locating surface for the tensioning element.

15. The receiver as claimed in one of the preceding claims, **characterized in that** in the regions, where solar cells (12) are arranged on the hollow profile (10), fins (20) are provided in the duct (11) for the heat transfer fluid of the hollow profile (10).

16. The receiver as claimed in claim 15, **characterized in that** the fins (20) are arranged in a discontinuous manner along the direction of flow of the heat transfer fluid in the duct (11).

17. The receiver as claimed in one of the preceding claims, **characterized in that** the solar cells (12) are concentrator photovoltaic cells and/or thermovoltaic cells.

18. The receiver as claimed in one of the preceding claims, **characterized in that** the two or more solar cells (12), which are arranged transversely in relation to the longitudinal extent of the receiver, are connected in parallel in pairs, and these pairs are connected in series, such a pair comprising two or more solar cells.

19. The receiver as claimed in claim 18, **characterized in that** there is a bypass diode (38) provided for one pair of solar cells (12) each.

20. The receiver as claimed in claim 19, **characterized in that** the bypass diode (38) is arranged directly on a common substrate with the pair of solar cells (12), the bypass diode (38) being realized without a housing and being protected by a reflector (39) that is mounted between the bypass diode (31) and the casing tube (13) and is not connected to the bypass diode (38).

21. A solar plant (1), having a linearly focusing mirror element (3), arranged in the focal line of which there is a receiver (4), the receiver (4) being constructed as claimed in one of claims 1 to 20 and being arranged in such a manner that the solar cells (12) of the receiver (4) face toward the linearly focusing mirror element (3).

22. The solar plant as claimed in claim 21, **characterized in that** the solar plant (1) comprises a Stirling engine, an Organic Rankine Cycle (ORC) system or a thermal refrigerating machine that is operated with heat transfer fluid heated in the receiver (4).

23. The solar plant as claimed in claim 21 or 22, **characterized in that** the solar plant (1) can track on one axis or on two axes.

## Revendications

1. Récepteur (4) pour l'agencement dans la ligne focale d'un collecteur solaire (1), avec un élément réfléchissant (3) à focalisation linéaire, dans lequel le récepteur comprend un profil creux (10) étiré en longueur avec un conduit traversant (11) pour fluide caloporteur et des cellules solaires (12) disposées sur un côté du profil creux (10), servant à transformer le rayonnement solaire en une énergie électrique, dans lequel les cellules solaires (12) et le profil creux (10) sont reliés de manière thermoconductrice, dans lequel au moins un élément de manipulation de rayons est disposé le long du profil creux (10) et dans lequel sont prévus en tant qu'élément de manipulation de rayons des éléments de concentrateur (21) servant à regrouper un rayonnement solaire arrivant sur le récepteur (4) avec une concentration linéaire en divers points focaux le long de la ligne focale, **caractérisé en ce que** le profil creux (10) est disposé avec les cellules solaires (12) disposées dessus dans un tube de gainage (13) transparent de manière à ce que les éléments de concentrateur (21) soient disposés entre le tube de gainage (13) et les cellules solaires (12) et la position du profil creux, des cellules solaires (12), du tube de gainage (13) et des éléments de concentrateur (21) les uns par rapport aux autres est fixe, et qu'est prévu au moins un élément de serrage, lequel entoure le profil creux (10) et au moins une cellule solaire (12) de telle manière que l'au moins une cellule solaire (12) est pressée au niveau du profil creux (10).

2. Récepteur selon la revendication 1, **caractérisé en ce qu'**est prévu en tant qu'élément de manipulation de rayons un séparateur de rayons (23), qui scinde le rayonnement solaire incident en différentes longueurs d'onde et le dévie respectivement sur des cellules solaires (12) optimisées par rapport aux différentes longueurs d'onde.

3. Récepteur selon l'une quelconque des revendications 1 à 2, **caractérisé en ce que** la zone entre le profil creux (10) et le tube de gainage (13) est mise sous vide ou est remplie de gaz rare.

4. Récepteur selon l'une quelconque des revendications précédentes, **caractérisé en ce que** sont prévus au niveau des deux extrémités du tube de gainage (13) des raccordements (41) servant au rinçage avec du gaz.

5. Récepteur selon l'une quelconque des revendications précédentes, **caractérisé en ce qu'**est prévu, sur le côté, opposé aux cellules solaires (12), du profil creux (10) entre le profil creux (10) et le tube de gainage (13) un réflecteur pour rejeter sur le profil creux (10) le rayonnement thermique provenant du profil creux (10) et/ou le rayonnement de fuite de l'élément de manipulation de rayons.

6. Récepteur selon l'une quelconque des revendications précédentes, **caractérisé en ce que** l'au moins un élément de manipulation de rayons est réalisé d'un seul tenant avec le tube de gainage (13).

7. Récepteur selon l'une quelconque des revendications précédentes, **caractérisé en ce qu'**une extension longitudinale thermique du profil creux (10) est réglée de telle sorte qu'elle est, en termes de valeur, à peu près égale à celle du tube de gainage (13).

8. Récepteur selon l'une quelconque des revendications précédentes, **caractérisé en ce que** le profil creux (10) est réalisé de manière demi-cylindrique ou de manière à présenter une forme de fer à cheval.

9. Récepteur selon l'une quelconque des revendications précédentes, **caractérisé en ce qu'**au moins un disque de maintien (25) est prévu pour positionner le profil creux (10) dans le tube de gainage (13), dont le contour extérieur est adapté à la paroi intérieure du tube de gainage (13).

10. Récepteur selon l'une quelconque des revendications précédentes, **caractérisé en ce que** des renfoncements (27) ou des parties surélevées (26) servant à recevoir par complémentarité de forme les cellules solaires (12) sont réalisés au niveau du profil creux (10).

11. Récepteur selon l'une quelconque des revendications précédentes, **caractérisé en ce que** l'au moins un élément de serrage est prévu sous la forme d'un élément de blocage (16) .

12. Récepteur selon la revendication 11, **caractérisé en ce que** l'élément de serrage présente dans sa zone agissant sur la cellule solaire (12) plusieurs doigts (25'), avec lesquels il appuie la cellule solaire (12) contre le profil creux (10) .

13. Récepteur selon la revendication 11 ou 12, **caractérisé en ce qu'**est disposé, entre l'élément de serrage et la cellule solaire (12), une plaque de pression (30) transparente rigide en flexion, laquelle enjambe une face avant de la cellule solaire (12).

14. Récepteur selon l'une quelconque des revendications précédentes, **caractérisé en ce qu'**un élargissement (40) est prévu à l'extérieur au niveau d'au moins un bord latéral d'un substrat supportant la cellule solaire (12), dans lequel l'élargissement (40) est réalisé de telle sorte qu'il forme une surface de support sans ombrage pour l'élément de serrage.

15. Récepteur selon l'une quelconque des revendications précédentes, **caractérisé en ce que** des ailerons (20) sont prévus dans les zones, dans lesquelles des cellules solaires (12) sont disposées au niveau du profil creux (10), dans le conduit traversant (11) pour le fluide caloporteur du profil creux (10).

16. Récepteur selon la revendication 15, **caractérisé en ce que** les ailerons (20) sont disposés en discontinu le long de la direction d'écoulement du fluide caloporteur dans le conduit de passage (11).

17. Récepteur selon l'une quelconque des revendications précédentes, **caractérisé en ce que** les cellules solaires (12) sont des cellules photovoltaïques de concentrateur et/ou des cellules thermovoltaïques.

18. Récepteur selon l'une quelconque des revendications précédentes, **caractérisé en ce que** les deux cellules solaires (12) ou plus, qui sont disposées de manière transversale par rapport à l'extension longitudinale du récepteur, sont branchées par paire en parallèle et lesdites paires sont branchées en série, dans lequel une telle paire comprend deux cellules solaires ou plus.

19. Récepteur selon la revendication 18, **caractérisé en ce que** pour chaque paire respectivement des cellules solaires (12), une diode de dérivation (38) est prévue.

20. Récepteur selon la revendication 19, **caractérisé en ce que** la diode de dérivation (38) est disposée sur un substrat commun avec la paire des cellules solaires (12), dans lequel la diode de dérivation (38) est réalisée sans boîtier et est protégée par un réflecteur (39) installé entre la diode de dérivation (38) et le tube de gainage (13) et non relié à la diode de dérivation (38).

21. Installation solaire (1) avec un élément réfléchissant (3) à focalisation linéaire, dans la ligne focale duquel est disposé un récepteur (4), dans laquelle le récepteur (4) est réalisé selon l'une quelconque des revendications 1 à 20 et est disposé de telle manière que les cellules solaires (12) du récepteur (4) sont tournées vers l'élément réfléchissant (3) à focalisation linéaire.

22. Installation solaire selon la revendication 21, **caractérisée en ce que** l'installation solaire (1) comprend un moteur Stirling, une installation ORC (organic rankine cycle, cycle de Rankine à fluide organique) ou une machine de réfrigération thermique, qui fonctionne avec du fluide caloporteur réchauffé dans le récepteur (4).

23. Installation solaire selon la revendication 21 ou 22, **caractérisée en ce que** l'installation solaire (1) peut être réalisée de manière ultérieure avec un axe ou avec deux axes.
